# EUROPÄISCHE PATENTSCHRIFT

(11) **EP 3 118 993 B1**
(45) Veröffentlichungstag und Bekanntmachung des Hinweises auf die Patenterteilung: **04.12.2019**
(21) Anmeldenummer: 16179326.0
(22) Anmeldetag: 13.07.2016
(51) Int. Cl.: H03G 3/32, H03G 7/00

(54) **VERFAHREN ZUR LAUTSTÄRKEANPASSUNG VON AUDIOSIGNALEN UNTERSCHIEDLICHER LAUTSTÄRKE**
METHOD FOR ADJUSTING THE VOLUME OF AUDIO SIGNALS OF DIFFERENT VOLUMES
PROCEDE D'ADAPTATION DU VOLUME DE SIGNAUX AUDIO DE DIFFERENTS VOLUMES

(30) Priorität: 15.07.2015 DE 102015111463
(43) Veröffentlichungstag der Anmeldung: 18.01.2017
(73) Patentinhaber: ASK Industries GmbH, 94559 Niederwinkling (DE)
(72) Erfinder: Stoutjesdijk, Remco, 00-154 Warszawa (PL); Vizzaccaro, Marco, 00019 Tivoli (IT)
(74) Vertreter: Hafner & Kohl Patent- und Rechtsanwälte Partnerschaft mbB

(56) Entgegenhaltungen:
- CN-A- 104 468 930
- DE-A1-102010 003 306
- DE-A1-102010 040 689

## Beschreibung

Die Erfindung betrifft ein Verfahren zur Lautstärkeanpassung von Audiosignalen unterschiedlicher Lautstärke, insbesondere von gespeicherten Musikdateien unterschiedlicher Herkunft, die als Klangfolge nacheinander wiedergegeben werden. Es ist bekannt, dass auf Musikabspielgeräten wie Computern oder MP3-Playern Musikdateien aus beliebigen Quellen zusammengeführt und abgespielt werden. Die einzige Voraussetzung besteht darin, dass das Abspielgerät die Kodierung wie "mp3", "ogg" oder "wav" kennt und somit in der Lage ist, die Musikdatei abzuspielen. Dabei werden unter Musikdatei auch Videodateien mit Audioanteil verstanden. Die Dateien sind dann zwar anders kodiert, die Problematik ist aber die gleiche.

Selbst bei den Titeln oder Liedern einer einzigen CD kann es vorkommen, dass sie eine unterschiedliche Lautstärke aufweisen.

Aus der DE 10 2010 003 306 A1 ist es bekannt zu jedem Audiosignal eine Regelungsinformation zu speichern und diese beim wiederholten Abspielen abzurufen und dementsprechend die Wiedergabe wie beim letztmaligen Abspielen vorzunehmen.

Die DE 102 32 645 A1 betrifft eine Schaltungsanordnung zur Verringerung des Dynamikbereichs von Audiosignalen. Dabei wird das Audiosignal in den Frequenzbereich transformiert, das erhaltene Spektrum bearbeitet und das bearbeitete Spektrum zurücktransformiert.

Aus der DE 102010040689 A1 ist ein Audiosystem bekannt, das eine erste Audioquelle zur Ausgabe eines ersten Audiosignals und eine zweite Audioquelle zur Ausgabe eines zweiten Audiosignals umfasst. Vorzugsweise werden die Audiosignale beider Audioquellen, beispielsweise nacheinander, durch eine gemeinsame Verstärkereinrichtung verstärkt und/ oder durch einen gemeinsamen Lautsprecher ausgegeben.

Aus der CN 104468930 A ist ein Verfahren zum Einstellen der Lautstärke eines Signals bekannt, wobei die Lautstärke auf der Grundlage eines Vergleichs zwischen einem Umgebungsschallsignal und dem Schallsignal eingestellt wird.

Dabei besteht das Problem, dass die Schaltungsanordnung eine aufwändige Signalverarbeitung erfordert und insbesondere eine durchgängige Hin- und Zurücktransformation des Audiosignals vom Zeit- in den Frequenzraum notwendig ist.

Diese Aufgabe wird durch ein Verfahren mit den Merkmalen des Anspruchs 1 gelöst.

Vorteilhafte Weiterbildungen ergeben sich aus den Unteransprüchen.

Als Kern der Erfindung wird angesehen, dass das Audiosignal in einer ersten Phase dynamikkomprimiert wird, d.h. dass der Dynamikumfang des Audiosignals verringert wird. Eine Phase ist dabei ein Zeitabschnitt. Dies verhindert ein Überschreiten der Lautstärke ohne vorhergehende Messungen. In dieser Phase wird dann die Lautstärke des Audiosignals ermittelt, um diese mit der Ziellautstärke zu vergleichen. Dieser Vergleich ergibt ein Belassen, Anheben oder Absenken der Lautstärke.

Mit Lautstärke ist dabei die Lautheit, also die vom Menschen wahrgenommene Lautstärke, gemeint. Im Gegensatz dazu ist als Messgröße der Schallpegel oder auch Schalldruckpegel bekannt. Die Lautstärke hängt dabei selbstverständlich auch vom Schalldruckpegel ab, aber eben nicht ausschließlich. Dies führt dazu, dass zwei Audiosignale mit gleichem Schalldruckpegel unterschiedlich laut wahrgenommen werden.

Die Lautstärke ist als psychoakustische Größe nicht direkt messbar, sie wird vielmehr aus messbaren Größen abgeleitet.

Ist der Vergleich der momentanen Lautstärke des Audiosignals mit der Ziellautstärke vollzogen wird die Lautstärke anhand des Vergleichsergebnisses angepasst und die Dynamikkompression beendet. Dann liegt die zweite Phase des Verfahrens vor.

Der Vorteil dieses Verfahrens zur Anpassung der Lautstärke liegt darin, dass die Lautstärke nur am Anfang eines Audiosignals angepasst wird und keine durchgehende Signaltransformation notwendig ist.

Vorzugsweise kann zur Ermittlung der Lautstärke das Verfahren nach Zwicker, auch Zwicker'sche Lautheitsberechnung genannt, verwendet werden. Bei diesem werden neben dem Schalldruckpegel auch die spektrale Zusammensetzung und andere Faktoren berücksichtigt.

Mit besonderem Vorteil wird zwischen der ersten Phase und der zweiten Phase eine Zwischenphase vorgesehen, in welcher die Dynamikkompression reduziert wird und die Anpassung der Lautstärke vorgenommen wird. Die Abschaltung der Dynamikkompression und die Anpassung der Lautstärke erfolgt also nicht in einem einzigen Schritt, sondern entweder in mehreren Schritten oder besonders bevorzugt stufenlos und somit kontinuierlich. Die Dauer der Zwischenphase kann dabei fest vorgegeben sein. In einer vorteilhaften Ausgestaltung ist die Dauer der Zwischenphase vom Abstand der momentanen Lautstärke zur Ziellautstärke abhängig. Zusätzlich kann die Dauer der Zwischenphase vom Einfluss der Dynamikkompression auf das Audiosignal abhängen. Ergibt der Vergleich der momentanen Lautstärke mit der Ziellautstärke, dass das Audiosignal sehr stark dynamikkomprimiert ist und eine vergleichsweise starke Anpassung notwendig ist, ist für diese insgesamt mehr Zeit notwendig als bei geringfügigen Abweichungen.

Vorteilhafterweise erfolgt die Reduktion der Dynamikkompression und die Anpassung der Lautstärke nichtlinear, d.h. anfangs erfolgt eine stärkere Anpassung als gegen Ende der Zwischenphase. Damit kann die Lautstärke in den Bereichen, in denen eine Änderung weniger auffällt, stärker geändert werden, d.h. dass die wahrgenommene Lautstärkeänderung im Zeitverlauf als konstante Änderung wahrgenommen wird.

Um bereits in der ersten Phase eine möglichst gute Anpassung zu erreichen ist vorzugsweise vorgesehen, dass die Dynamikkompression und die Lautstärke jeweils über einen Vorgabewert eingestellt werden und der Vorgabewert in Abhängigkeit der Audioquelle vorgegeben wird. Als Audioquelle können als Geräte angesehen werden, die Audiosignale, also mit dem Ohr wahrnehmbare Signale, ausgeben. Dies sind insbesondere CD-Spieler, Radios, DVD-Spieler, MP3-Spieler, etc. Es kann sich dabei auch um eine Navigationseinrichtung handeln.

Jede der Audioquellen gibt ein Audiosignal an die das Signal weiter verwertenden Einrichtungen wie einen Kompressor oder anderen Verstärker oder Lautsprecher mit einer anderen Grundlautstärke aus. Bekanntermaßen muss an einem Fernseher oft die Lautstärke korrigiert werden, wenn ein Film statt über einen Receiver über einen DVD-Spieler abgespielt wird. Eine erste Anpassung der Lautstärke und der Dynamikkompression erfolgt also dadurch, dass diese in Abhängigkeit der Audioquelle eingestellt werden. Durch diese erste Anpassung bereits ganz am Anfang der ersten Phase kann die mögliche Differenz zwischen der Lautstärke der ersten und der zweiten Phase verringert werden.

Eine weitere Aufgabe stellt es dar, den Zeitpunkt des Wechsels eines Audiosignals festzustellen. Wenn die Steuerungseinrichtung, die das Verfahren ausführt, entsprechende Signale, in diesem Fall keine Audiosignale, abfragen kann, kann über diese Status-Signale der Wechselzeitpunkt festgelegt werden. Beispielsweise ist es bekannt, die einzelnen Audiosignale auf CDs, in diesem Fall Lieder oder sonstige Signaleinheiten wie ein Sketch oder die Aufnahme einer Vogelstimme, mit Metadaten zu versehen, sodass der CD-Spieler "weiß", wann ein Audiosignal endet und demnach ein neues Audiosignal in der Folge beginnt. Kann die Steuerungseinrichtung auf derartige Informationen in Form von Signalen zugreifen kann der Wechsel von einem Audiosignal zum nächsten sicher festgestellt werden.

Andernfalls ist es bevorzugt vorgesehen, dass der Wechsel von einem Audiosignal zum nächsten anhand einer vorgegebenen Signalfolge festgelegt wird. Insbesondere weist es auf einen Wechsel hin, wenn als Signalfolge wenigstens einige Millisekunden lang eine digitale "0" auftritt. Dies tritt normalerweise nur zwischen zwei Audiosignalen oder beim Wechsel der Audioquelle auf aber nicht innerhalb eines Audiosignals.

Zusätzlich kann vorgesehen sein, die Lautstärke auch während oder nach der zweiten Phase zu analysieren, also zu ermitteln und mit der Referenzlautstärke zu vergleichen. Es ist möglich, dass die in der ersten Phase ermittelte Lautstärke, die nur auf Basis einer kurzen Sequenz vorgenommen wird, nicht für das gesamte Audiosignal repräsentativ ist. Die wiederholte Überprüfung der Lautstärke stellt sicher, dass keine Fehleinstellung der Lautstärke vorgenommen wurde.

Weiterhin kann vorgesehen sein, dass die Lautstärke in Abhängigkeit der Lautstärke der Umgebung angepasst wird, insbesondere indem die Ziellautstärke in Abhängigkeit der Umgebungslautstärke festgelegt wird. Die Umgebung ist der Bereich, der den Hörer des Audiosignals umgibt. In einem Kraftfahrzeug kann die Umgebungslautstärke davon abhängen, wo sich das Kraftfahrzeug bewegt. Beispielsweise ergibt sich mit zunehmender Fahrgeschwindigkeit ohne sonstige Einflüsse eine größere Umgebungslautstärke. Es ist also nicht zwingend notwendig, die Umgebungslautstärke mit einem Mikrofon oder dergleichen aufzunehmen. Die Umgebungslautstärke kann auch aufgrund von Betriebsdaten eines Kraftfahrzeugs bestimmt werden.

Die Ziellautstärke ist eine Lautstärke, die sich daraus ergibt, dass ein Audiosignal in seiner Lautstärke durch einen Hörer mittels eines Eingabemittels, bspw. eines Drehknopfs, eingestellt wurde. Diese einmal gewählte Lautstärke wird als Ziellautstärke gespeichert, entweder als Zahlenwert oder als abfragbare Position eines Drehknopfes. Die folgenden Audiosignale werden in der Lautstärke dann an die so gewählte und festgelegte Ziellautstärke angeglichen. Um die Ziellautstärke zu ermitteln kann also die Lautstärke nach der Betätigung des Eingabemittels bestimmt und abgespeichert werden.

Die Implementierung der vorgenannten Verfahren in einer Steuerungseinrichtung kann dabei als Software oder aber auch als (fest verdrahtete) Hardware erfolgen.

Daneben betrifft die Erfindung auch Audiowiedergabeeinrichtung zur Verarbeitung von Audiosignalen. Diese zeichnet sich aus durch eine Ermittlungseinheit zur Ermittlung einer Lautstärke eines Audiosignals, einen Speicher zum Speichern einer Ziellautstärke, eine Vergleichseinheit zum Vergleichen der ermittelten Lautstärke mit der gespeicherten Ziellautstärke und eine Anpassungseinrichtung zur Anpassung der Lautstärke des Audiosignals.

Weitere vorteilhafte Ausgestaltungen der Audiowiedergabeeinrichtung korrespondieren zu entsprechenden Ausgestaltungen des erfindungsgemäßen Verfahrens. Zur Vermeidung unnötiger Wiederholungen wird somit auf die entsprechenden Verfahrensmerkmale und deren Vorteile verwiesen. Dabei gilt, dass ein Verfahrensschritt als entsprechende "Einheit" realisiert ist. Wenn also bspw. verfahrensgemäß vorgesehen ist, dass die Dynamikkompression über einen Vorgabewert eingestellt wird und der Vorgabewert in Abhängigkeit der Audioquelle vorgegeben wird, dann weist die Audiowiedergabeeinrichtung eine Vorgabeeinheit zum Einstellen eines Vorgabewerts in Abhängigkeit der Audioquelle auf, wobei die Dynamikkompression über den Vorgabewert einstellbar ist. Allgemein sind Werte in der Audiowiedergabeeinrichtung einstellbar und verwendbar, wenn sie verfahrensgemäß eingestellt und verändert werden.

Im Folgenden wird die Erfindung anhand von Ausführungsbeispielen in den Zeichnungsfiguren näher erläutert. Dabei zeigen:
- Fig. 1: eine Audioanlage,
- Fig. 2: Signalwege während der Wiedergabe eines Audiosignals,
- Fig. 3: ein Audiosignal in einer ersten Ausgestaltung,
- Fig. 4: ein Audiosignal in einer zweiten Ausgestaltung,
- Fig. 5: ein Audiosignal in einer dritten Ausgestaltung,
- Fig. 6: ein Audiosignal in einer vierten Ausgestaltung, und
- Fig. 7: ein Audiosignal in einer fünften Ausgestaltung.

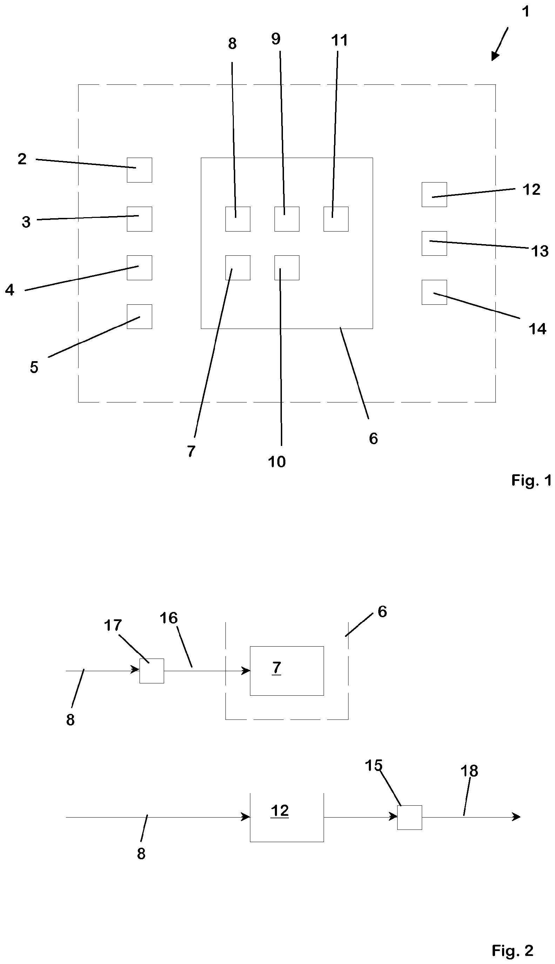

Fig. 1 zeigt eine Audioanlage 1 mit einem CD-Spieler 2, einem MP3-Spieler 3 und einem Radio 4 als Audioquellen, wobei weiterhin ein USB-Anschluss 5 vorgesehen ist, mit dem ein MP3 bevorratender USB-Stick anschließbar ist. Die Steuerungseinrichtung 6 regelt die Wiedergabe der aus dem CD-Spieler 2, dem MP3-Spieler 3 oder dem Radio 4 stammenden Audiosignale. Als Audiosignal wird dabei eine zusammenhängende Einheit, bspw. ein Track auf einer CD, angesehen. Ein Audiosignal setzt sich aus mehreren Unterelementen wie Bytes zusammen. Mehrere Audiosignale hintereinander werden als Klangfolge wiedergegeben. Audiosignalen sind nicht nur Musikstücke, es kann sich auch um Sprachaufführungen, einzelne Kapitel eines Hörbuchs oder Ansagen eines Navigationssystems handeln.

Die Steuerungseinrichtung 6 umfasst eine Ermittlungseinheit 7 zur Ermittlung der Lautstärke eines Audiosignals 8, einen Speicher 9 zum Speichern einer Ziellautstärke, eine Vergleichseinheit 10 zum Vergleichen der ermittelten Lautstärke mit der gespeicherten Ziellautstärke und eine Ausgabeeinheit 11 zur Ausgabe von Steuerungssignalen.

Weiterhin umfasst die Audioanlage 1 einen Kompressor 12, einen Verstärker 13 und wenigstens einen Lautsprecher 14.

Die Audioanlage 1 kann weitere Bauteile besitzen, diese sind nicht dargestellt, soweit sie für die vorliegende Anmeldung nicht relevant sind.

Figur 2 zeigt die Signalwege während der ersten Phase der Wiedergabe eines Audiosignals. In Abhängigkeit der Audioquelle wird der Kompressor 12 eingestellt. Je nachdem, ob das Audiosignal 8 aus dem CD-Spieler 2, dem MP3-Spieler 3 oder dem Radio 4 stammt wird der Dynamikumfang des Audiosignals 8 unterschiedlich begrenzt. Diese Einstellung wird über die Steuerungseinrichtung 6 vorgenommen, die eine Einheit zum Abfragen der Audioquelle aufweist. Das ankommende Audiosignal 8 wird entsprechend als im Dynamikumfang begrenztes Audiosignal 15 aus dem Kompressor 12 ausgegeben.

Gleichzeitig wird der Ermittlungseinheit 7 das Ermittlungssignal 16 zugeführt. Bei einem Monosignal kann es sich um das Audiosignal 8 handeln, bei einem Stereosignal wird das Audiosignal 8 durch einen Mixer 17 zum Ermittlungssignal 16 gemischt. Der Mixer 17 mischt das Audiosignal 8 so, dass die Lautstärke des Ermittlungssignals 16 der Lautstärke des an den Lautsprechern ausgegebenen Audiosignals, die ein Hörer aufgrund der Lautsprecherpositionen empfindet, möglichst nahe kommt.

In der ersten Phase wird mithilfe der Zwicker'schen Lautheitsberechnung die Lautstärke des Ermittlungssignals 16 ermittelt und an der Vergleichseinheit mit einer im Speicher 9 abgespeicherten Ziellautstärke verglichen.

Als Ergebnis des Vergleichs kann sich ein Belassen, Erhöhen oder Verringern der Lautstärke ergeben. In der folgenden Zwischenphase wird die Dynamikkompression stufenlos verringert und die Lautstärke je nach Vergleichsergebnis angepasst, also in die Ziellautstärke überführt. Die Zwischenphase beginnt also mit dem Vorliegen des Vergleichsergebnisses bzw. mit dem Anpassen der Lautstärke, wobei die Anpassung mit Vorliegen des Vergleichsergebnisses unmittelbar begonnen wird.

Danach kann das Audiosignal 15 weiteren Verarbeitungsschritten unterzogen werden, um als ausgehendes Audiosignal 18 dem Lautsprecher 14 zugeführt zu werden.

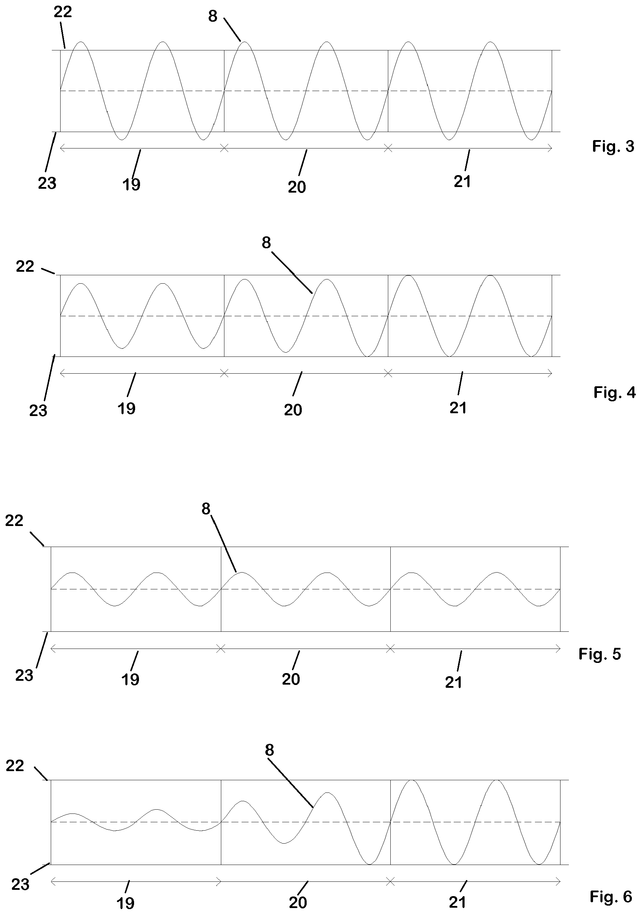

Figur 3 zeigt ein Audiosignal 8 ohne Dynamikkompression in einer ersten Phase 19, einer Zwischenphase 20 und einer zweiten Phase 21. Die Linien 22 und 23 zeigen die gewünschten Grenzen des Dynamikumfangs an, die über die Ziellautstärke vorgegeben sind. Das Audiosignal 8 ist zu laut, d.h. seine Lautstärke liegt über der Ziellautstärke und die Amplitude überschreitet daher die Linien 22 und 23.

Figur 4 zeigt das Audiosignal 18, das in der ersten Phase 19 dem Audiosignal 8 mit Dynamikkompression entspricht. Das Audiosignal 18 könnte die Linien 22 und 23 auch geringfügiger als in Figur 3 aber überschreiten, da die Dynamikkompression in der ersten Phase 19 die Lautstärke des Audiosignals 18 soweit herabsetzen soll, dass die Ziellautstärke nicht überschritten wird.

In der Zwischenphase 20 nähert sich die Lautstärke des Audiosignals 18 der Ziellautstärke stufenlos an, wobei die Dynamikkompression ebenso stufenlos reduziert wird.

In der zweiten Phase 21 ist die Ziellautstärke erreicht, die Dynamikkompression beendet und die Amplituden des Audiosignals 18 berühren die Grenzen 22 und 23 tangential.

Die Figuren 5 und 6 zeigen analog zu den Figuren 3 und 4 Audiosignale 8 und 18, wobei die Lautstärke des Audiosignals 8 niedriger ist als die Ziellautstärke. Dementsprechend wird die Lautstärke des Audiosignals 18 in der Zwischenphase 20 stufenlos angehoben.

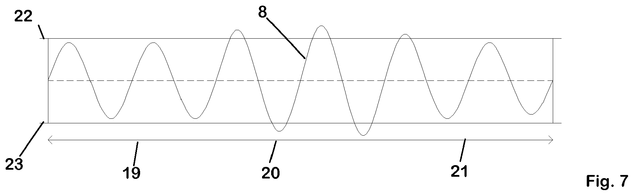

Figur 7 zeigt schließlich ein Audiosignal 8, dessen Lautstärke in der zweiten Phase 21 wechselt, nämlich größer wird. Während in der ersten Hälfte noch eine Anhebung der Lautstärke notwendig ist um die Ziellautstärke zu erreichen bedarf es in der zweiten Hälfte einer Reduzierung. Es ist daher vorgesehen, dass in der zweiten Phase 21 wenigstens eine weitere Analyse der Lautstärke des Audiosignals 8 bzw. des daraus abgeleiteten Ermittlungssignals 16 erfolgt und bei einer Abweichung von der Ziellautstärke eine Dynamikkompression des Audiosignals 8 vorgenommen wird.

### BEZUGSZEICHENLISTE

- 1: Audioanlage
- 2: CD-Spieler
- 3: MP3-Spieler
- 4: Radio
- 5: USB- Anschluss
- 6: Steuerungseinrichtung
- 7: Ermittlungseinheit
- 8: Audiosignal
- 9: Speicher
- 10: Vergleichseinheit
- 11: Ausgabeeinheit
- 12: Kompressor
- 13: Verstärker
- 14: Lautsprecher
- 15: Audiosignal
- 16: Ermittlungssignal
- 17: Mixer
- 18: Audiosignal
- 19: erste Phase
- 20: Zwischenphase
- 21: zweite Phase
- 22: Linie
- 23: Linie

## Patentansprüche

1. Verfahren zur Lautstärkeanpassung von Audiosignalen (8) unterschiedlicher Lautstärke, insbesondere von gespeicherten Musikdateien aus unterschiedlichen Audioquellen (2, 3, 4), die als Klangabfolge nacheinander wiedergegeben werden, **gekennzeichnet durch die Schritte:**
- Vorgabe einer Ziellautstärke für alle nacheinander wiederzugebenden Audiosignale (8),
- Ermittlung der Lautstärke eines Audiosignals (8) in einer ersten Phase (19) seiner Wiedergabe, wobei
- die Lautstärke des Audiosignals (8) ermittelt wird, um diese mit der Ziellautstärke zu vergleichen,
- Anwendung einer Dynamikkompression auf das Audiosignal (8), wobei der Dynamikumfang des Audiosignals (8) verringert wird, während dieser ersten Phase (19),nach Abschluss der Ermittlung der Lautstärke während der ersten Phase (19) Anhebung oder Absenkung der Lautstärke zur Anpassung an die Ziellautstärke während einer zweiten Phase (21), und
- Beendigung der Anwendung der Dynamikkompression auf das Audiosignal beim Übergang von der ersten Phase zur zweiten Phase (21).

2. Verfahren nach Anspruch 1, **dadurch gekennzeichnet, dass** zwischen der ersten Phase (19) und der zweiten Phase (21) eine Zwischenphase (20) vorgesehen wird, in welcher die Dynamikkompression reduziert wird und die Anpassung der Lautstärke vorgenommen wird.

3. Verfahren nach Anspruch 2, **dadurch gekennzeichnet, dass** die Reduzierung der Dynamikkompression und die Anpassung der Lautstärke stufenlos vorgenommen wird.

4. Verfahren nach einem der vorhergehenden Ansprüche, **dadurch gekennzeichnet, dass** während oder nach der zweiten Phase (21) wenigstens eine weitere Ermittlung der Lautstärke erfolgt und bei einer Abweichung von der Ziellautstärke eine Dynamikkompression des Audiosignals (8) vorgenommen wird.

5. Verfahren nach einem der Ansprüche 2 bis 4, **dadurch gekennzeichnet, dass** die Ziellautstärke in Abhängigkeit der Lautstärke der Umgebung vorgegeben wird.

6. Verfahren nach einem der vorangehenden Ansprüche, **dadurch gekennzeichnet, dass** die Lautstärke mit der Methode nach Zwicker ermittelt wird.

7. Verfahren nach einem der vorangehenden Ansprüche, **dadurch gekennzeichnet, dass** das Audiosignal der Zuführung zu einer Ermittlungseinheit (7) zur Ermittlung der Lautstärke in einem Mischer (17) gemischt wird.

8. Verfahren nach einem der vorhergehenden Ansprüche, **dadurch gekennzeichnet, dass** die Dynamikkompression über einen Vorgabewert eingestellt wird und der Vorgabewert in Abhängigkeit der Audioquelle (2, 3, 4) vorgegeben wird.

9. Verfahren nach Anspruch 8, **dadurch gekennzeichnet, dass** als Audioquelle ein Radio (4) und/oder ein CD-Spieler (2) und/oder ein MP3-Spieler (3) und/oder ein DVD-Abspielgerät verwendet werden.

10. Audioregeleinrichtung (6) zur Verarbeitung von Audiosignalen (8), **dadurch gekennzeichnet, dass** die Audioregeleinrichtung (6) eine Ermittlungseinheit (7) zur Ermittlung der Lautstärke eines Audiosignals (8), einen Speicher (9) zum Speichern einer Ziellautstärke, eine Vergleichseinheit (10) zum Vergleichen der ermittelten Lautstärke mit der gespeicherten Ziellautstärke, eine Ausgabeeinheit (11) zum Ausgeben von Steuerungssignalen und einen Kompressor (12) umfasst, wobei der Kompressor (12) in Abhängigkeit der mit der Ausgabeeinheit ausgegebenen Steuerungssignale steuerbar ist, wobei die Audioregeleinrichtung (6) zur Lautstärkeanpassung von Audiosignalen (8) unterschiedlicher Lautstärke, insbesondere von gespeicherten Musikdateien aus unterschiedlichen Audioquellen (2, 3, 4), die als Klangabfolge nacheinander wiedergegeben werden, und zur
- Vorgabe einer Ziellautstärke für alle nacheinander wiederzugebenden Audiosignale (8),
- Ermittlung der Lautstärke eines Audiosignals (8) in einer ersten Phase (19) seiner Wiedergabe, wobei die Lautstärke des Audiosignals (8) ermittelt wird, um diese mit der Ziellautstärke zu vergleichen,
- Anwendung einer Dynamikkompression auf das Audiosignal (8), wobei der Dynamikumfang des Audiosignals (8) verringert wird, während dieser ersten Phase (19),nach Abschluss der Ermittlung der Lautstärke während der ersten Phase (19) Anhebung oder Absenkung der Lautstärke zur Anpassung an die Ziellautstärke während einer zweiten Phase (21), und
- Beendigung der Anwendung der Dynamikkompression auf das Audiosignal beim Übergang von der ersten Phase zur zweiten Phase (21),
konfiguriert ist.

11. Audioregeleinrichtung (6) nach Anspruch 10, **dadurch gekennzeichnet, dass** die Audioregeleinrichtung (6) einen Mischer zum Mischen eines Audiosignals (8) aufweist.

## Claims

1. Method for adjusting the volume of audio signals (8) of different volume, in particular of stored music files from different audio sources (2, 3, 4), which are reproduced after one another as a sound sequence, **characterised by the steps:**
- specification of a target volume for all audio signals (8) to be reproduced after one another,
- determination of the volume of an audio signal (8) in a first phase (19) of its reproduction, wherein
- the volume of the audio signal (8) is determined, in order to compare this with the target volume,
- application of dynamic compression to the audio signal (8), wherein the dynamic range of the audio signal (8) is reduced, during this first phase (19), after completion of determining the volume during the first phase (19) increasing or reducing the volume for adjustment to the target volume during a second phase (21), and
- termination of the application of compression to the audio signal on the transition from the first phase to the second phase (21).

2. Method according to claim 1, **characterised in that** there is provided between the first phase (19) and the second phase (21) an intermediate phase (20), in which the compression is reduced and the adjustment of the volume is made.

3. Method according to claim 2, **characterised in that** the reduction in compression and the adjustment of the volume are undertaken steplessly.

4. Method according to any one of the preceding claims, **characterised in that** during or after the second phase (21) at least one further determination of the volume takes place and in the event of deviation from the target volume, a dynamic compression of the audio signal (8) is undertaken.

5. Method according to one of claims 2 to 4, **characterised in that** the target volume is specified as a function of the volume of the environment.

6. Method according to any one of the preceding claims, **characterised in that** the volume is determined using the Zwicker method.

7. Method according to any one of the preceding claims, **characterised in that** the audio signal of supply to a determination unit (7) for determining the volume is mixed in a mixer (17).

8. Method according to any one of the preceding claims, **characterised in that** the dynamic compression is set using a default value and the default value is specified as a function of the audio source (2, 3, 4).

9. Method according to claim 8, **characterised in that** a radio (4) and/or a CD player (2) and/or an MP3 player (3) and/or a DVD player are used as an audio source.

10. Audio regulation device (6) for processing audio signals (8), **characterised in that** the audio regulation device (6) comprises a determination unit (7) for determining the volume of an audio signal (8), a memory (9) for storing a target volume, a comparison unit (10) for comparing the determined volume with the stored target volume, an output unit (11) for outputting control signals and a compressor (12), wherein the compressor (12) can be controlled as a function of the control signals output by the output unit, wherein the audio regulation device (6) is configured to adjust the volume of audio signals (8) of different volume, in particular of stored music files from different audio sources (2, 3, 4), which are reproduced after one another as a sound sequence, and to
- specify a target volume for all audio signals (8) to be reproduced after one another,
- determine the volume of an audio signal (8) in a first phase (19) of its reproduction, wherein the volume of the audio signal (8) is determined in order to compare this with the target volume,
- apply a compression to the audio signal (8), wherein the dynamic range of the audio signal (8) is reduced, during this first phase (19), on completion of the determination of the volume during the first phase (19) to increase or reduce the volume for adjustment to the target volume during a second phase (21) and
- terminate the application of compression to the audio signal on the transition from the first phase to the second phase (21).

11. Audio regulation device (6) according to claim 10, **characterised in that** the audio regulation device (6) comprises a mixer for mixing an audio signal (8).

## Revendications

1. Procédé d'adaptation du volume sonore de signaux audio (8) à volume sonore différent, en particulier de fichiers musicaux mémorisés issus de différentes sources audio (2, 3, 4), qui sont reproduits les uns après les autres en tant que séquence sonore, **caractérisé par les étapes** :
- de spécification d'un volume sonore cible pour tous les signaux audio (8) à reproduire les uns après les autres,
- de détermination du volume sonore d'un signal audio (8) lors d'une première phase (19) de sa reproduction, dans lequel
- le volume sonore du signal audio (8) est déterminé pour comparer celui-ci au volume sonore cible,
- d'utilisation d'une compression dynamique sur le signal audio (8), dans lequel la gamme dynamique du signal audio (8) est réduite, pendant ladite première phase (19), une fois la détermination du volume sonore achevée pendant la première phase (19), d'augmentation ou d'abaissement du volume sonore aux fins de l'adaptation au volume sonore cible pendant une deuxième phase (21), et
- de fin de l'utilisation de la compression dynamique sur le signal audio lors du passage de la première phase vers la deuxième phase (21).

2. Procédé selon la revendication 1, **caractérisé en ce qu'**est prévue entre la première phase (19) et la deuxième phase (21), une phase intermédiaire (20), dans laquelle la décompression dynamique est réduite et l'adaptation du volume sonore est effectuée.

3. Procédé selon la revendication 2, **caractérisé en ce que** la réduction de la compression dynamique et l'adaptation du volume sonore sont effectuées en continu.

4. Procédé selon l'une quelconque des revendications précédentes, **caractérisé en ce que** pendant ou après la deuxième phase (21), au moins une autre détermination du volume sonore a lieu et, en cas d'écart par rapport au volume sonore cible, une compression dynamique du signal audio (8) est effectuée.

5. Procédé selon l'une quelconque des revendications 2 à 4, **caractérisé en ce que** le volume sonore cible est spécifié en fonction du volume sonore de l'environnement.

6. Procédé selon l'une quelconque des revendications précédentes, **caractérisé en ce que** le volume sonore est déterminé avec la méthode de Zwicker.

7. Procédé selon l'une quelconque des revendications précédentes, **caractérisé en ce que** le signal audio est mixé lors de l'amenée à une unité de détermination (7) servant à déterminer le volume sonore dans un mixeur (17).

8. Procédé selon l'une quelconque des revendications précédentes, **caractérisé en ce que** la compression dynamique est réglée au moyen d'une valeur de spécification et la valeur de spécification est spécifiée en fonction de la source audio (2, 3, 4).

9. Procédé selon la revendication 8, **caractérisé en ce qu'une** radio (4) et/ou un lecteur de CD (2) et/ou un lecteur de MP3 (3) et/ou un appareil de lecture de DVD sont utilisés en tant que source audio.

10. Dispositif de réglage audio (6) de traitement de signaux audio (8), **caractérisé en ce que** le dispositif de réglage audio (6) comprend une unité de détermination (7) servant à déterminer le volume sonore d'un signal audio (8), une mémoire (9) servant à mémoriser un volume sonore cible, une unité de comparaison (10) servant à comparer le volume sonore déterminé au volume sonore cible mémorisé, une unité de sortie (11) servant à faire sortir des signaux de commande et un compresseur (12), dans lequel le compresseur (12) peut être commandé en fonction des signaux de commande envoyés avec l'unité de sortie, dans lequel le dispositif de réglage audio (6) est configuré aux fins de l'adaptation du volume sonore de signaux audio (8) à volume sonore différent, en particulier de fichiers musicaux mémorisés issus de différentes sources audio (2, 3, 4), qui sont reproduits les uns après les autres en tant que séquence sonore, et aux fins
- de la spécification d'un volume sonore cible pour tous les signaux audio (8) à reproduire les uns après les autres,
- de la détermination du volume sonore d'un signal audio (8) lors d'une première phase (19) de sa reproduction, dans lequel le volume sonore du signal audio (8) est déterminé pour comparer ce dernier au volume sonore cible,
- d'utilisation d'une compression dynamique sur le signal audio (8), dans lequel la gamme dynamique du signal audio (8) est réduite, pendant ladite première phase (19), une fois la détermination du volume sonore terminée pendant la première phase (19), d'augmentation ou d'abaissement du volume sonore aux fins de l'adaptation au volume sonore cible pendant une deuxième phase (21), et
- de fin de l'utilisation de la compression dynamique sur le signal audio lors du passage de la première phase vers la deuxième phase (21).

11. Dispositif de réglage audio (6) selon la revendication 10, **caractérisé en ce que** le dispositif de réglage audio (6) présente un mixeur servant à mixer un signal audio (8).
